# EUROPEAN PATENT SPECIFICATION

(11) **EP 2 610 901 B1**
(45) Date of publication and mention of the grant of the patent: **19.02.2020**
(21) Application number: 11819739.1
(22) Date of filing: 28.07.2011
(51) Int. Cl.: H01L 21/67

(54) **SHEET ATTACHING DEVICE AND ATTACHING METHOD**
FOLIENBEFESTIGUNGSVORRICHTUNG UND BEFESTIGUNGSVERFAHREN
DISPOSITIF ET PROCÉDÉ DE COLLAGE DE FEUILLE

(30) Priority: 26.08.2010 JP 2010189688
(43) Date of publication of application: 03.07.2013
(73) Proprietor: LINTEC Corporation, Tokyo 173-0001 (JP)
(72) Inventor: TAKANO Takeshi, Tokyo 173-0001 (JP)
(74) Representative: Hoffmann Eitle
(86) International application number: PCT/JP2011/067195
(87) International publication number: WO 2012/026274

(56) References cited:
- WO-A1-02/056352
- WO-A1-2005/057651
- DE-A1-102005 060 456
- JP-A- 2008 042 016
- JP-A- 2008 294 026
- JP-A- 2008 294 026
- JP-A- 2009 295 847
- JP-A- 2010 118 584

## Description

### TECHNICAL FIELD

The present invention relates to a system comprising a sheet attaching device and a sheet attaching method for attaching an adhesive sheet to an adherend.

### BACKGROUND ART

A sheet attaching device for attaching an adhesive sheet such as a protection sheet, mounting sheet, dicing tape and die-bonding tape on a semiconductor wafer (adherend: sometimes simply referred to as a "wafer" hereinafter) has conventionally been employed in a semiconductor manufacturing process. Some of the sheet attaching devices are adapted to attach an adhesive sheet without creating a gap between an adherend and the adhesive sheet. An example of such a sheet attaching device includes a table disposed in a chamber for supporting a wafer, in which an adhesive sheet is disposed above a surface of the wafer and a roller is rolled on the adhesive sheet after the atmosphere in the chamber is decompressed, so that the adhesive sheet is pressed to be temporarily attached. Subsequently, the adherend and the adhesive sheet are exposed to an atmospheric pressure, thereby attaching the adhesive sheet on the surface of the wafer (see, for instance, JP-A-2001-68394). With the use of such a device, even when a gap is created between the adherend and the adhesive sheet when the adhesive sheet is temporarily attached under the decompressed atmosphere, the gap can be eliminated when the adherend and the adhesive sheet are exposed to the atmospheric pressure.

JP-A-2008-294026 discloses a combination of features falling within the scope of the pre-characterizing portion of Claim 1.

Incidentally, when there are irregularities on a to-be-attached surface of an attached, even after an adhesive sheet is temporarily attached on the adherend under decompressed atmosphere and the adherend and the adhesive sheet are exposed to an atmospheric pressure, the gap created around the irregularities cannot be completely eliminated. Accordingly, the gap between the adherend and the adhesive sheet remains after the adhesive sheet is attached. This is because a pressure difference between an inside and an outside of the gap is balanced with a tension of the adhesive sheet and therefore is insufficient for eliminating the gap. The above disadvantages become prominent as the size of the irregularities becomes large.

Further, in order to integrate an adherend and a frame with an adhesive sheet, when the adhesive sheet is temporarily attached in a chamber of a decompressed atmosphere or by rolling a roller on the adhesive sheet, the adhesive sheet between the adherend and the frame is plastically deformed due to a tension applied thereon, so that the adhesive sheet is stretched and slacked. Thus, since the adherend is integrated in a manner capable of displacement relative to the frame, the adherend cannot be reliably held and consequently may be damaged.

An object of the invention is therefore to provide a sheet attaching device and a sheet attaching method for attaching an adhesive sheet to an adherend without creating a gap or slacking the adhesive sheet.

### SUMMARY OF THE INVENTION

According to a first aspect of the present invention, there is provided a sheet attaching device arranged to attach an adhesive sheet on an adherend, the sheet attaching device comprising: a sheet support arranged to support the adhesive sheet placed opposite to the adherend; a decompression unit arranged to keep the adherend and the adhesive sheet placed opposite to the adherend in a decompressed atmosphere; an attaching unit arranged to bring the adhesive sheet close to the adherend under the decompressed atmosphere to attach the adhesive sheet to the adherend; and a gap removal unit arranged to remove a gap present between the adherend and the adhesive sheet after the adhesive sheet is attached on the adherend, characterized in that: the gap removal unit is provided outside the decompression unit; and the sheet attaching device comprises a transfer unit arranged to transfer the adherend attached with the adhesive sheet to the gap removal unit.

In the sheet attaching device according to the above aspect of the invention, it is preferable that the sheet support is arranged to support an outer periphery of the adhesive sheet, the decompression unit defines a first space and a second space that are mutually independent on both sides of the adhesive sheet, and the attaching unit is arranged to set a pressure in the first space to be higher than a pressure in the second space to bend the adhesive sheet toward the adherend by virtue of a differential pressure between the first space and the second space to bring the adhesive sheet close to the adherend.

Further, in the sheet attaching device according to the above aspect of the invention, it is preferable that the adhesive sheet is sized to protrude beyond an outer periphery of the adherend and is attached in advance on an opening of a frame, and the gap removal unit is adapted to heat or cool a part of the adhesive sheet protruded beyond the outer periphery of the adherend.

According to a second aspect of the present invention, there is provided a sheet attaching method for attaching an adhesive sheet on an adherend, the method comprising: supporting the adhesive sheet placed opposite to the adherend; keeping the adherend and the adhesive sheet placed opposite to the adherend in a decompressed atmosphere; bringing the adhesive sheet close to the adherend under the decompressed atmosphere to attach the adhesive sheet to the adherend; and removing a gap present between the adherend and the adhesive sheet after the adhesive sheet is attached on the adherend, characterized in that: the method further comprises transferring the adherend attached with the adhesive sheet before removing the gap.

According to the above aspect of the invention, even if a gap is created between the adherend and the adhesive sheet when the adhesive sheet is attached on the adherend under a decompressed atmosphere or atmospheric pressure, a stretch margin can be generated on the adhesive sheet covering the gap by, for instance, heating the adhesive sheet by the gap removal unit, so that the adhesive sheet is closely attached to the adherend due to the pressure difference between inside and outside of the gap. Thus, the adhesive sheet can be attached on the adherend without creating a gap. Incidentally, in the above-described related art, since the adhesive sheet is attached on the adherend while the adhesive sheet has been stretched by heating, no more stretch margin is generated on the adhesive sheet even when an atmospheric pressure is applied on the adhesive sheet by introducing atmospheric pressure in a chamber, so that a gap remains between the adhesive sheet and the adherend. In the present invention, since the adhesive sheet is attached on the adherend without being heated, the adhesive sheet has been attached on the adherend while retaining the stretch margin when being heated under the atmospheric pressure. Thus, the gap can be reliably eliminated.

In the above aspect of the invention, when the gap removal unit is provided outside the decompression unit, the gap-removal step of the adhesive sheet attached on the adherend and the attaching step of the next pair of the adherend and the adhesive sheet can be performed in an overlapped manner, so that the efficiency of the adhesion process per a unit time can be enhanced.

Further, when a central area of the adhesive sheet is bent to be brought close to the adherend by the differential pressure between the first space and the second space that are separated by the adhesive sheet, the adhesive sheet can be gradually attached on the adherend from the central area to an outer periphery of the adherend. Thus, since the outer periphery of the adhesive sheet is not attached prior to the central area, the adhesive sheet can be attached on the adherend while keeping the gap created between the adhesive sheet and the adherend to a minimum.

Further, when the adhesive sheet sized to protrude beyond the outer periphery of the adherend is attached on the opening of the frame in advance and the part of the adhesive sheet protruded beyond the outer periphery of the adherend is adapted to be heated or cooled, the adhesive sheet is cooled or heated to an ambient temperature to be contracted after the heating or cooling, so that the slacking of the adhesive sheet between the adherend and the frame can be eliminated. Thus, the displacement of the adherend relative to the frame is not allowed and the adherend can be reliably held to the frame, thereby avoiding damages on the adherend in advance.

### BRIEF DESCRIPTION OF DRAWINGS

To enable a better understanding of the present invention, and to show how the same may be carried into effect, reference will now be made, by way of example only, to the accompanying drawings, in which:-
Fig. 1 is a partial sectional side elevation showing a sheet attaching device according to an exemplary embodiment of the invention;
Fig. 2A is an illustration showing an operation of the sheet attaching device;
Fig. 2B is another illustration showing the operation of the sheet attaching device;
Fig. 2C is still another illustration showing the operation of the sheet attaching device;
Fig. 3 is an illustration showing another operation of the sheet attaching device;
Fig. 4A shows a condition of an adhesive sheet after being attached;
Fig. 4B shows the condition of the adhesive sheet after being attached;
Fig. 5A shows another condition of the adhesive sheet after being attached;
Fig. 5B shows the condition of the adhesive sheet after being attached;
Fig. 6A shows still another condition of the adhesive sheet after being attached; and
Fig. 6B shows the condition of the adhesive sheet after being attached.

### DETAILED DESCRIPTION

Exemplary embodiment(s) of the invention will be described below with reference to the attached drawings.

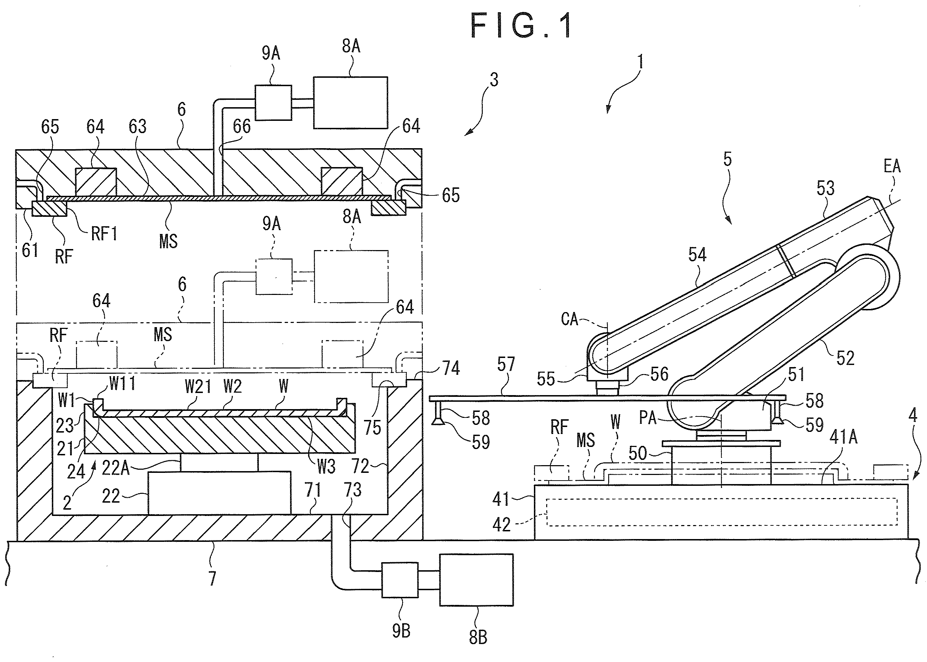

As shown in Fig. 1, a sheet attaching device 1 according to this exemplary embodiment is for attaching a mounting sheet MS (adhesive sheet) that is attached in advance to close an opening RF1 of a ring frame RF to a wafer W (adherend) to integrate the wafer W and the ring frame RF with the mounting sheet MS. The wafer W is a semiconductor wafer that is ground to provide an outer periphery thicker than the rest of the wafer, whereby an annular convex portion W1 protruded in the thickness direction (toward a back side) is defined on an outer periphery, a cavity W2 is defined at an inside surrounded by the convex portion W1 and a circuitry is formed on a circuit face W3 on a top side (i.e. a side opposite to the ground face and at a lower side in Fig. 1) of the wafer W. A protection sheet (not shown) is attached on the circuit face W3. Further, the mounting sheet MS has a layered structure in which an adhesive layer is laminated on one side of a base material sheet (not shown).

As shown in Fig. 1, the sheet attaching device 1 includes: an adherend support unit 2 that supports the wafer W; a decompression unit 3 that holds the mounting sheet MS at a position opposing the wafer W and keeps the wafer W and the mounting sheet MS in a decompressed atmosphere; a gap removal unit 4 that is provided outside the decompression unit 3 and removes a gap present between the wafer W and the mounting sheet MS after the wafer W is attached on the mounting sheet MS; and a multijoint robot 5 (transport unit, drive unit) that transfers the wafer W attached with the mounting sheet MS to the gap removal unit 4.

The adherend support unit 2 includes a disc-shaped table 21 having a profile larger than an outer periphery of the wafer W, and a linear movement motor 22 (drive unit) having an output shaft 22A fixed on a lower face of the table 21. An annular convex portion 23 of which an outer periphery protrudes in thickness direction (upward in Fig. 1) is provided on an upper face 24 of the table 21.

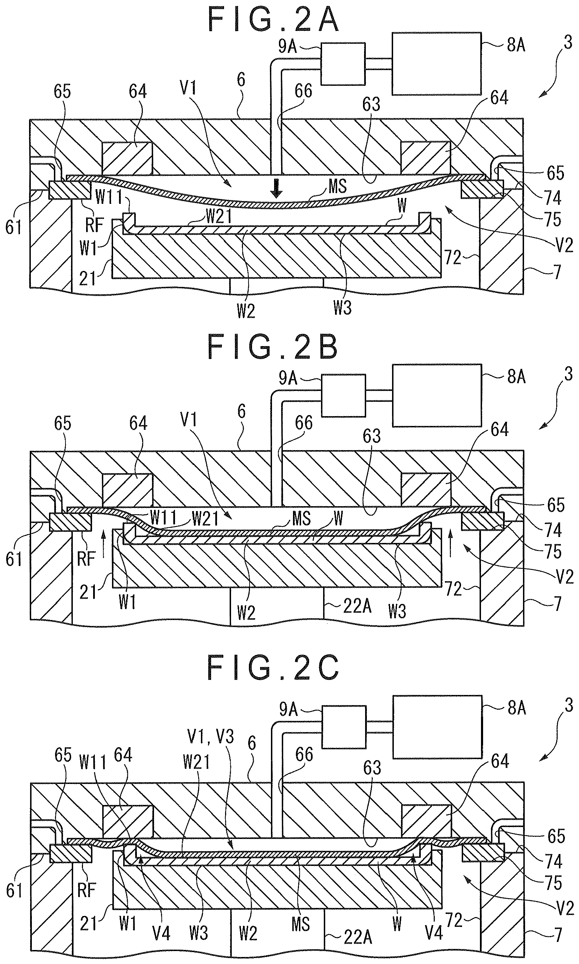

The decompression unit 3 includes a cover member 6 and a lower chamber 7 (sheet supports) that support the mounting sheet MS attached on the ring frame RF in a manner opposed with the wafer W, a pressure adjuster 8A (an attaching unit) that is adapted to decompress an inside of a first space V1 defined by the cover member 6 and the mounting sheet MS (see Fig. 2A) and a pressure adjuster 8B (an attaching unit) that is adapted to decompress an inside of a second space V2 (see Fig. 2A) defined by the mounting sheet MS and the lower chamber 7.

The cover member 6 is capable of vertical movement by a drive unit (not shown). On a lower face 61 of the cover member 6, a frame holder 63 having concave cross section with the same profile as an outer profile of the ring frame RF, and an elastic member 64 that is embedded in the frame holder 63 with a surface thereof being exposed on the frame holder 63 are provided. A part of the frame holder 63 under which the ring frame RF is located is provided with a plurality of suction holes 65 and is provided by an elastic member to keep the sealability of the first space V1 by conforming with the height gap created by the mounting sheet MS. A pressure adjustment channel 66 connected to the pressure adjuster 8A is provided to the frame holder 63. A pressure detector 9A for detecting a pressure in the first space V1 is provided in the pressure adjustment channel 66.

The lower chamber 7 is provided in a box shape having an opening at an upper face 74 thereof. Specifically, the lower chamber 7 includes a bottom face 71 at which the adherend support unit 2 is provided and a lateral face 72 extending upward from an outer periphery of the bottom face 71. A pressure adjustment channel 73 connected to the pressure adjuster 8B is provided to the bottom face 71. A pressure detector 9B for detecting a pressure in the second space V2 is provided in the pressure adjustment channel 73. A recessed annular support 75 is provided at an inner side of the upper face 74 of the lateral face 72. The ring frame RF attached with the mounting sheet MS is adapted to be supported by the support 75.

In the decompression unit 3, the mounting sheet MS defines separate first space V1 and second space V2. The pressure adjusters 8A and 8B adjust the pressure in the first and second spaces V1 and V2 to press and attach the mounting sheet MS to the wafer W with the use of the differential pressure between the first space V1 and second space V2.

The gap removal unit 4 includes a table 41 on which the wafer W integrated with the ring frame RF via the mounting sheet MS is placed and a heater 42 that is provided in the table 41 and is adapted to heat the mounting sheet MS.

The multijoint robot 5 includes: a base 50; a first arm 51 that is held on the base in a manner rotatable around a vertical axis PA (an axis in up-down direction) relative to the base 50; a second arm 52 that is pivotally supported on the first arm 51 in a manner rotatable around a horizontal axis orthogonal to the vertical axis PA (an axis orthogonal to a plane of Fig. 1); a third arm 53 pivotally supported on the second arm 52 in a manner rotatable around the horizontal axis; a fourth arm 54 pivotally supported on the third arm 53 in a manner rotatable around an extension axis EA of the third arm 53; a fifth arm 55 that is pivotally supported on the fourth arm 54 in a manner rotatable around an axis orthogonal to the extension axis EA (an axis orthogonal to the plane of Fig. 1); a sixth arm 56 that is pivotally supported on the fifth arm 55 in a manner rotatable around an extension axis CA of the fifth arm 55; a frame 57 provided to the sixth arm 56; and suction pads 59 provided via four holder arms 59 (partly not shown) vertically provided on the frame 57 and at an angular interval of 90 degrees. The multijoint robot 5 is adapted to hold the wafer W and the ring frame RF integrated via the mounting sheet MS with the suction pads 59.

A process for attaching the mounting sheet MS on the wafer W in the above-described sheet attaching device 1 will be described below.

Initially, the ring frame RF in which the opening RF1 is closed by the mounting sheet MS is sucked and held on the cover member 6 and the wafer W is mounted on the table 21, with the use of a transfer unit (not shown) as shown in Fig. 1. Subsequently, the decompression unit 3 lowers the cover member 6 by a drive unit (not shown) to bring the lower face 61 of the cover member 6 into contact with the upper face 74 of the lower chamber 7. After the first and second spaces V1 and V2 are defined by the cover member 6 and the lower chamber 7, the pressure adjusters 8A and 8B vacuumize or decompress the first and second spaces V1 and V2 so that the pressures in the first and second spaces V 1 and V2 are equalized while decompressing the first and second spaces V1 and V2 at an equal decompression rate.

Next, the decompression unit 3 sets the pressure in the first space V1 to be higher than the pressure in the second space V2 by the pressure adjusters 8A and 8B while keeping the decompressed state of the first and second spaces V1 and V2. Then, as shown in Fig. 2A, the mounting sheet MS is urged toward the second space V2 due to the differential pressure between the first and the second spaces V1 and V2 and is bent so that a central part thereof comes closest to the wafer W. In this condition, when the linear movement motor 22 is driven to elevate the table 21, the mounting sheet MS is gradually attached on the wafer W from a central portion to an outer periphery of the wafer W as shown in Fig. 2B. Then, as shown in Fig. 2C, when the mounting sheet MS is pressed and is kept being pressed onto the elastic member 64 of the cover member 6 by the top face W11 of the convex portion W1, a new third space V3 is created in the first space V1 and between an inside of the elastic member 64 and the mounting sheet MS and a new fourth space V4 (gap) is created in the second space V2 and between the mounting sheet MS and the wafer W.

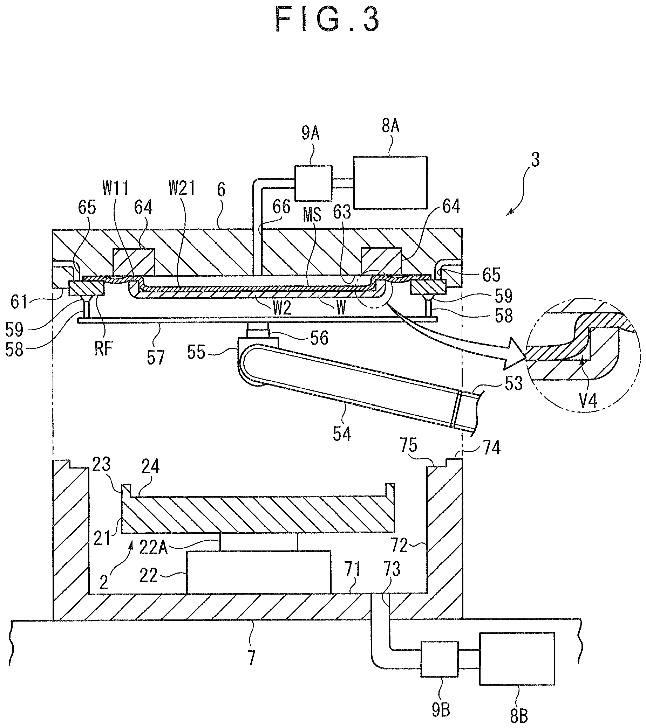

Subsequently, the pressure in the second space V2 is set to be equal to the pressure in the first space V1 by the pressure adjuster 8B. Then, the decompression unit 3 increases the pressures in the third and second spaces V3 and V2 with the pressure adjusters 8A and 8B at the same pressure-increase rate to gradually return the pressures to an atmospheric pressure. Thus, the fourth space V4 is gradually shrunk being urged by the pressure in the third space V3 through the mounting sheet MS and, when the pressure difference between the third space V3 and the fourth space V4 is balanced with the tension of the mounting sheet MS, the fourth space V4 stops shrinking (see Fig. 3). Then, while the ring frame RF is sucked and held via the suction holes 65, the decompression unit 3 lifts the cover member 6 to a predetermined level with the use of a drive unit (not shown). As shown in Fig. 3, the multijoint robot 5 sucks and holds a part of the ring frame RF with the suction pads 59 and places the wafer W on the table 41 with the mounting sheet MS facing a mount face 41 A of the table 41.

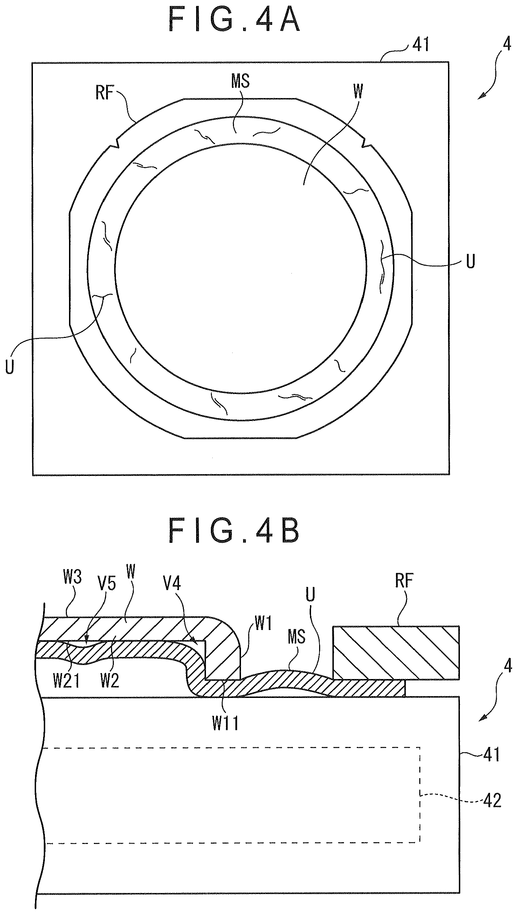

The mounting sheet MS immediately before being heated by the gap removal unit 4 is bent so that the central portion of the mounting sheet MS comes closest to the wafer W before being attached on the wafer W. Accordingly, as shown in Fig. 4A, the mounting sheet MS has irregular waviness U (slack) in a form of ruffles between the wafer W and the ring frame RF. Further, as shown in Fig. 4B, a fifth space V5 (gap) may be present in addition to the fourth space V4.

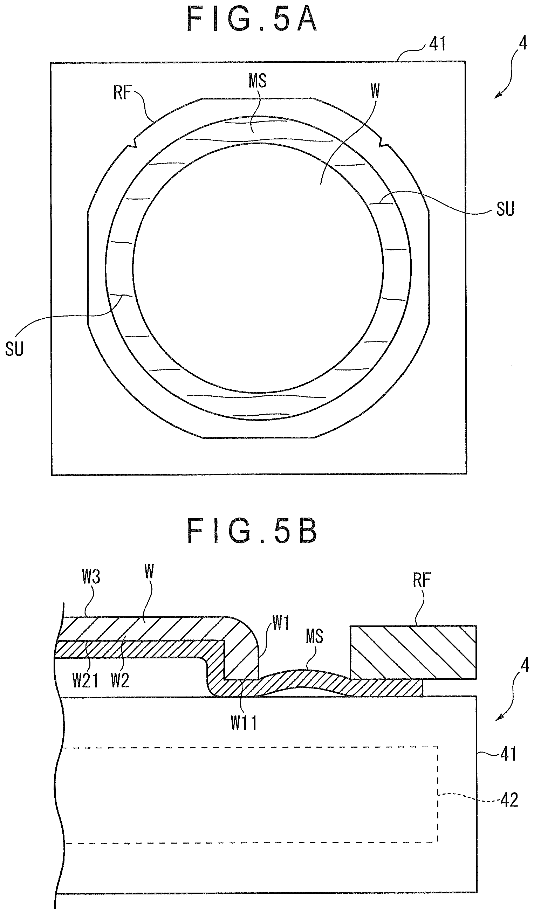

When the mounting sheet MS placed on the table 41 is heated by the gap removal unit 4, a stretch margin is generated on the mounting sheet MS. Then, as shown in Fig. 5B, the mounting sheet MS is closely attached on the wafer W due to pressure difference against the atmospheric pressure to eliminate the fourth and fifth spaces V4 and V5.

Further, when the mounting sheet MS is heated, the mounting sheet MS is stretched in a direction in which tension is applied by the ring frame RF so that the waviness U is transformed into a plurality of lines SU extending in a predetermined direction, as shown in Fig. 5A.

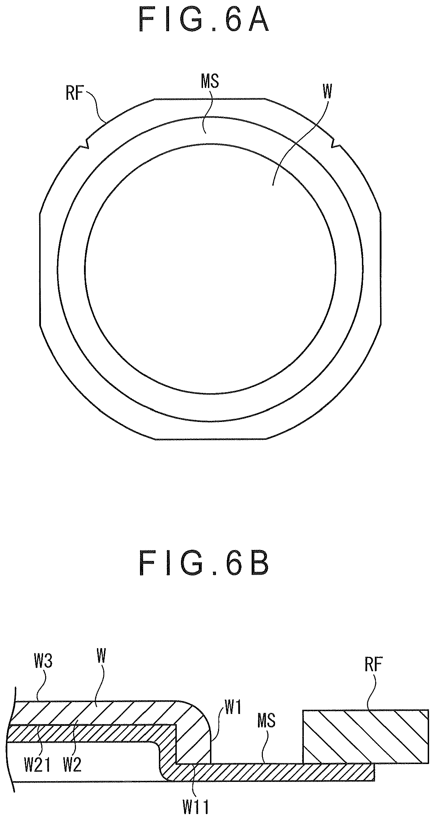

After a predetermined time elapsed, the multijoint robot 5 sucks and holds a part of the ring frame RF with the suction pads 59 and lifts up the mounting sheet MS from the table 41. Then, the mounting sheet MS is naturally cooled to an ambient temperature and the mounting sheet MS is drawn to be contracted by the tension of the ring frame RF to eliminate the lines SU and the slack emerged during the heating as shown in Figs. 6A and 6B. Thus, the displacement of the wafer W relative to the ring frame RF is no more allowed, thereby avoiding damages on the wafer W. It is speculated that the slack is eliminated due to a cause related to a residual stress remained in a base material of the mounting sheet MS that is generated when the base material is stretched for forming the mounting sheet MS.

When the mounting sheet MS is completely attached as discussed above and the wafer W and the ring frame RF are integrated via the mounting sheet MS, the wafer W and the ring frame RF are transferred by the multijoint robot 5 to a next step (e.g. step for peeling the protection sheet).

According to the above-described exemplary embodiment, the following advantages can be obtained.

Even if the space V4 is created between the wafer W and the mounting sheet MS when the mounting sheet MS is attached on the wafer W under decompressed atmosphere or atmospheric pressure, the sheet attaching device 1 is adapted to heat the mounting sheet MS to generate the stretch margin on the mounting sheet MS at the part of the space V4. Thus, since the mounting sheet MS is closely attached to the wafer W being drawn by an internal pressure (negative pressure) in the space V4, the mounting sheet MS can be attached on the wafer W without creating the space V4 (gap).

The best arrangement and process for implementing the invention has been described above. However, it should be understood that the scope of the invention is limited by the appended set of claims. In other words, while the invention has been particularly explained and illustrated mainly in relation to a specific embodiment, a person skilled in the art could make various modifications in terms of shape, material, quantity or other particulars to the above described embodiment without deviating from the technical idea or any object of the present invention. Further, any descriptions of shape, material or quantity or the like disclosed above are given as examples to enable easy understanding of the invention, and do not limit the present invention, so that descriptions using names of components, with any such limitations of shape, material or quantity or the like removed in part or whole, are included in the present invention.

For instance, though an example in which the adherend is the wafer W is discussed in the above exemplary embodiment, the adherend is not restricted to the wafer W, and the ring frame RF may be omitted. Alternatively, the adherend may be a plate member such as a glass plate, steel plate and resin plate or a member that is not plate-shaped. The examples of the wafer W include silicon semiconductor wafer, a compound semiconductor wafer or the like. The adhesive sheet to be attached to the adherend may be, instead of the mounting sheet MS, an adhesive sheet for any application to be attached on a plate-shaped member and of any shape such as a sheet, film and tape. Further, though the wafer W attached with a protection sheet on a circuit face thereof is used in the above exemplary embodiment, the protection sheet may not be attached on the wafer W. Further, the irregularities formed on the wafer W may be a bump (an electrode on a semiconductor chip) and the like instead of the convex portion W1.

Though the mounting sheet MS attached with the ring frame RF is supported by the cover member 6 and the lower chamber 7 of the decompression unit 3 in the above exemplary embodiment, the sheet support is not limited to the cover member 6 and the lower chamber 7. For instance, the cover member 6 may be provided in a form of a box as in the lower chamber 7 and a table for supporting the ring frame RF and the mounting sheet MS may be provided on the lower face 61 of the cover member 6. Alternatively, an outer peripheral table may be provided on the bottom face 71 of the lower chamber 7 to surround the adherend support unit 2 and the mounting sheet MS attached with the ring frame RF may be supported on the table.

Further, though the cover member 6, lower chamber 7 and multijoint robot 5 hold a part of the ring frame RF to hold the wafer W and the mounting sheet MS in the above exemplary embodiment, the mounting sheet MS may be held.

In the above exemplary embodiment, the pressure in the first space V1 in which the wafer W is not present is set higher than the pressure in the second space V2 in which the wafer W is present by the pressure adjuster 8A to attach the mounting sheet MS on the wafer W. However, the mounting sheet MS may be attached on the wafer W by a different attaching means. For instance, the pressure in the second space V2 may be set lower than the pressure in the first space V1 by the pressure adjuster 8B. Alternatively, an attaching roller may be provided and the attaching roller may be rolled on the mounting sheet MS to attach the mounting sheet MS onto the wafer W.

Though the wafer W integrated with the ring frame RF is placed on the table 41 so that the mounting sheet MS faces the mount face 41 A of the table 41 and the gap removal unit 4 heats the mounting sheet MS, the arrangement is not limited thereto. For instance, in a manner opposite to the exemplary embodiment, the wafer W and the ring frame RF may be placed on the table 41 to face the mount surface 41 A, and the mounting sheet MS may be indirectly heated (directly or through air) by heating the wafer W and the ring frame RF with the gap removal unit 4.

Further, though the heater 42 is used as the gap removal unit 4 in the above exemplary embodiment, the arrangement is not limited thereto. In other words, the gap removal unit 4 may be in any form as long as the mounting sheet MS can be directly or indirectly heated. For instance, infrared-ray irradiation equipment or microwave applicator may be used instead of the heater 42. Further, a heating unit such as the heater 42 may be provided outside the table 41 and the mounting sheet MS may be heated by the heater 42 from above or from a lateral side.

The gap removal unit 4 may be a component that is adapted to generate a stretch margin on the mounting sheet MS in process other than heating. For instance, when the base material of the mounting sheet MS is provided by a rubber that is more stretchable when being cooled, the gap removal unit 4 may be provided by a cooler in a form of such a Peltier element and the like that is adapted to cool the mounting sheet MS.

Further, though the table 21 of the adherend support unit 2 and the table 41 of the gap removal unit 4 are provided as independent components in the above exemplary embodiment, the table 21 of the adherend support unit 2 may have the heater or cooler therein to remove the gap.

Though the multijoint robot 5 is used in the above exemplary embodiment, the transfer unit is not limited to the multijoint robot 5. In other words, any transfer unit may be used as long as the wafer W attached with the mounting sheet MS is transferrable to the gap removal unit 4. For instance, the table 41 including the heater 42 may be provided to be slidably driven by a uniaxial robot and, when the cover member 6 is separated from the lower chamber 7, the table 41 may be moved between the cover member 6 and the lower chamber 7 to transfer the ring frame RF attached with the mounting sheet MS to the cover member 6 or the wafer W attached with the mounting sheet MS may be drawn out from the cover member 6.

Further, the drive unit mentioned in the above exemplary embodiment may be provided by: motorized equipment such as a rotary motor, linear movement motor, linear motor, uniaxial robot and multijoint robot; an actuator such as an air cylinder, hydraulic cylinder, rodless cylinder; or a direct or an indirect combination of the motorized equipment and/or actuator, which may be the same as those mentioned in the exemplary embodiment.

### EXPLANATION OF CODES

- 1: sheet attaching device
- 3: decompression unit
- 4: gap removal unit
- 5: multijoint robot (transfer unit)
- 6: cover member (sheet support)
- 7: lower chamber (sheet support)
- 8A, 8B: pressure adjuster (attaching unit)
- MS: mounting sheet (adhesive sheet)
- RF: ring frame (frame)
- V1: first space
- V2: second space
- W: wafer (adherend)

## Claims

1. A sheet attaching device (1) arranged to attach an adhesive sheet (MS) on an adherend (W), the sheet attaching device comprising:
a sheet support (6, 7) arranged to support the adhesive sheet (MS) placed opposite to the adherend (W);
a decompression unit (3) arranged to keep the adherend (W) and the adhesive sheet (MS) placed opposite to the adherend (W) in a decompressed atmosphere;
an attaching unit (8A, 8B) arranged to bring the adhesive sheet (MS) close to the adherend (W) under the decompressed atmosphere to attach the adhesive sheet (MS) to the adherend (W); and
a gap removal unit (4) arranged to remove a gap present between the adherend (W) and the adhesive sheet (MS) after the adhesive sheet (MS) is attached on the adherend (W),
**characterized in that**:
the gap removal unit (4) is provided outside the decompression unit (3); and
the sheet attaching device comprises a transfer unit (5) arranged to transfer the adherend (W) attached with the adhesive sheet (MS) to the gap removal unit (3).

2. The sheet attaching device according to Claim 1, wherein
the sheet support (6, 7) is arranged to support an outer periphery of the adhesive sheet (MS),
the decompression unit (3) defines a first space and a second space that are mutually independent on both sides of the adhesive sheet (MS), and
the attaching unit (8A, 8B) is arranged to set a pressure in the first space to be higher than a pressure in the second space to bend the adhesive sheet (MS) toward the adherend (W) by virtue of a differential pressure between the first space and the second space to bring the adhesive sheet (MS) close to the adherend (W).

3. The sheet attaching device according to claim 1 or 2, wherein the adhesive sheet (MS) is sized to protrude beyond an outer periphery of the adherend (W) and is attached in advance on an opening of a frame (RF) and the gap removal unit (4) is adapted to heat or cool a part of the adhesive sheet (MS) protruded beyond the outer periphery of the adherend (W).

4. A sheet attaching method for attaching an adhesive sheet (MS) on an adherend (W), the method comprising:
supporting the adhesive sheet (MS) placed opposite to the adherend (W);
keeping the adherend (W) and the adhesive sheet (MS) placed opposite to the adherend (W) in a decompressed atmosphere;
bringing the adhesive sheet (MS) close to the adherend (W) under the decompressed atmosphere to attach the adhesive sheet (MS) to the adherend (W); and
removing a gap present between the adherend (W) and the adhesive sheet (MS) after the adhesive sheet (MS) is attached on the adherend (W),
**characterized in that**:
the method further comprises transferring the adherend (W) attached with the adhesive sheet (MS) before removing the gap.

## Patentansprüche

1. Folienanbringungsvorrichtung (1), die eingerichtet ist, um eine Klebefolie (MS) an einer Klebefläche (W) anzubringen, wobei die Folienanbringungsvorrichtung Folgendes umfasst:
einen Folienträger (6, 7), der eingerichtet ist, um die Klebefolie (MS) zu tragen, die gegenüber der Klebefläche (W) angeordnet ist;
eine Unterdruckeinheit (3), die eingerichtet ist, um die Klebefläche (W) und die Klebefolie (MS), die gegenüber der Klebefläche (W) angeordnet ist, in einer Unterdruckatmosphäre zu halten;
eine Anbringungseinheit (8A, 8B), die eingerichtet ist, um die Klebefolie (MS) nahe an die Klebefläche (W) in der Unterdruckatmosphäre zu bringen, um die Klebefolie (MS) an der Klebefläche (W) anzubringen; und
eine Lückenunterdrückungseinheit (4), die eingerichtet ist, um eine Lücke zu unterdrücken, die zwischen der Klebefläche (W) und der Klebefolie (MS) vorhanden ist, nachdem die Klebefolie (MS) an der Klebefläche (W) angebracht wurde,
**dadurch gekennzeichnet, dass**:
die Lückenunterdrückungseinheit (4) außerhalb der Unterdruckeinheit (3) bereitgestellt wird; und
die Folienanbringungsvorrichtung eine Übertragungseinheit (5) umfasst, die eingerichtet ist, um die Klebefläche (W) mit der daran angebrachten Klebefolie (MS) auf die Lückenunterdrückungseinheit (3) zu übertragen.

2. Folienanbringungsvorrichtung nach Anspruch 1, wobei
der Folienträger (6, 7) eingerichtet ist, um eine äußere Peripherie der Klebefolie (MS) zu tragen,
die Unterdruckeinheit (3) einen ersten Raum und einen zweiten Raum definiert, die auf beiden Seiten der Klebefolie (MS) voneinander unabhängig sind, und
die Anbringungseinheit (8A, 8B) eingerichtet ist, um einen Druck in dem ersten Raum einzustellen, damit er höher als ein Druck in dem zweiten Raum ist, um die Klebefolie (MS) in Richtung auf die Klebefläche (W) anhand eines Differenzdrucks zwischen dem ersten Raum und dem zweiten Raum zu biegen, um die Klebefolie (MS) nahe an die Klebefläche (W) zu bringen.

3. Folienanbringungsvorrichtung nach Anspruch 1 oder 2, wobei die Klebefolie (MS) dimensioniert ist, um über eine äußere Peripherie der Klebefläche (W) hinaus überzustehen, und im Voraus an einer Öffnung eines Rahmens (RF) angebracht wird, und die Lückenunterdrückungseinheit (4) geeignet ist, um einen Teil der Klebefolie (MS), der über die äußere Peripherie der Klebefläche (W) übersteht, zu erhitzen oder abzukühlen.

4. Folienanbringungsverfahren zum Anbringen einer Klebefolie (MS) an einer Klebefläche (W), wobei das Verfahren folgende Schritte umfasst:
Tragen der Klebefolie (MS), die gegenüber der Klebefläche (W) angeordnet ist;
Halten der Klebefläche (W) und der Klebefolie (MS), die gegenüber der Klebefläche (W) angeordnet ist, in einer Unterdruckatmosphäre;
Bringen der Klebefolie (MS) in die Nähe der Klebefläche (W) in der Unterdruckatmosphäre, um die Klebefolie (MS) an der Klebefläche (W) anzubringen; und
Unterdrücken einer Lücke, die zwischen der Klebefläche (W) und der Klebefolie (MS) vorhanden ist, nachdem die Klebefolie (MS) an der Klebefläche (W) angebracht wurde,
**dadurch gekennzeichnet, dass**:
das Verfahren weiter das Übertragen der Klebefläche (W) mit der daran angebrachten Klebefolie (MS) umfasst, bevor die Lücke unterdrückt wird.

## Revendications

1. Dispositif d'attachement de feuille (1) agencé pour attacher une feuille adhésive (MS) sur une surface à coller (W), le dispositif d'attachement de feuille comprenant:
un support de feuille (6, 7) agencé pour supporter la feuille adhésive (MS) placée en face de la surface à coller (W) ;
une unité de décompression (3) agencée pour conserver la surface à coller (W) et la feuille adhésive (MS) placée en face de la surface à coller (W) dans une atmosphère décompressée ;
une unité d'attachement (8A, 8B) agencée pour amener la feuille adhésive (MS) près de la surface à coller (W) sous l'atmosphère décompressée pour attacher la feuille adhésive (MS) à la surface à coller (W) ; et
une unité d'enlèvement d'espacement (4) agencée pour enlever un espacement présent entre la surface à coller (W) et la feuille adhésive (MS) après que la feuille adhésive (MS) est attachée sur la surface à coller (W),
**caractérisé en ce que** :
l'unité d'enlèvement d'espacement (4) est disposée à l'extérieur de l'unité de décompression (3) ; et
le dispositif d'attachement de feuille comprend une unité de transfert (5) agencée pour transférer la surface à coller (W) attachée avec la feuille adhésive (MS) à l'unité d'enlèvement d'espacement (3).

2. Dispositif d'attachement de feuille selon la revendication 1, dans lequel
le support de feuille (6, 7) est agencé pour supporter une périphérie extérieure de la feuille adhésive (MS),
l'unité de décompression (3) définit un premier espace et un second espace qui sont mutuellement indépendants des deux côtés de la feuille adhésive (MS), et
l'unité d'attachement (8A, 8B) est agencée pour fixer une pression dans le premier espace pour qu'elle soit plus élevée qu'une pression dans le second espace pour plier la feuille adhésive (MS) vers la surface à coller (W) en vertu d'une pression différentielle entre le premier espace et le second espace pour amener la feuille adhésive (MS) près de la surface à coller (W).

3. Dispositif d'attachement de feuille selon la revendication 1 ou 2, dans lequel la feuille adhésive (MS) est dimensionnée pour avancer au-delà d'une périphérie extérieure de la surface à coller (W) et est attachée en avant sur une ouverture d'un châssis (RF) et l'unité d'enlèvement d'espacement (4) est conçue pour chauffer ou refroidir une partie de la feuille adhésive (MS) avancée au-delà de la périphérie extérieure de la surface à coller (W).

4. Procédé d'attachement de feuille pour attacher une feuille adhésive (MS) sur une surface à coller (W), le procédé comprenant :
le support de la feuille adhésive (MS) placée en face de la surface à coller (W) ;
la conservation de la surface à coller (W) et de la feuille adhésive (MS) placée en face de la surface à coller (W) dans une atmosphère décompressée ;
l'amenée de la feuille adhésive (MS) près de la surface à coller (W) sous l'atmosphère décompressée pour attacher la feuille adhésive (MS) à la surface à coller (W) ; et
l'enlèvement d'un espacement présent entre la surface à coller (W) et la feuille adhésive (MS) après que la feuille adhésive (MS) est attachée sur la surface à coller (W),
**caractérisé en ce que** :
le procédé comprend en outre le transfert de la surface à coller (W) attachée avec la feuille adhésive (MS) avant l'enlèvement de l'espacement.
